Europäisches Patentamt

European Patent Office

Office européen des brevets

(19)

(11) Publication number: **0 020 088**
**B1**

# EUROPEAN PATENT SPECIFICATION

(12)

(45) Date of publication of patent specification: **04.04.84**

(21) Application number: **80301689.8**

(22) Date of filing: **21.05.80**

(51) Int. Cl.³: **B 08 B 1/04,** G 03 F 1/00,
B 08 B 11/00

(54) **Apparatus for cleaning glass masks.**

(30) Priority: **28.05.79 JP 71625/79 U**

(43) Date of publication of application:
**10.12.80 Bulletin 80/25**

(45) Publication of the grant of the patent:
**04.04.84 Bulletin 84/14**

(84) Designated Contracting States:
**DE FR GB NL**

(56) References cited:
**FR - A - 2 063 961**
**US - A - 3 939 514**
**US - A - 4 109 337**

(73) Proprietor: **FUJITSU LIMITED**
**1015, Kamikodanaka Nakahara-ku**
**Kawasaki-shi Kanagawa 211 (JP)**

(72) Inventor: **Yoshizawa, Takeshi**
**1-17-10-304, Yurigaoka Tama-ku**
**Kawasaki-shi, Kanagawa 215 (JP)**

(74) Representative: **Jennings, Roy Alfred et al,**
**GILL JENNINGS & EVERY 53-64 Chancery Lane**
**London WC2A 1HN (GB)**

Courier Press, Leamington Spa, England.

Apparatus for cleaning glass masks

The present invention relates to apparatus for cleaning glass masks which are used in the manufacture of semiconductor devices. The apparatus comprises a pair of rotary cleaning members having cleaning surfaces which will wipe simultaneously both faces of a glass mask in a cleaning position between the cleaning surfaces, means for supplying cleaning liquid between the members, supporting means for supporting a cassette in which a plurality of glass masks are contained, and means for carrying the glass masks one by one between a position in the cassette and the cleaning position.

In the process of photolithography for making semiconductor wafers, usually a semiconductor wafer and a glass mask are exposed to light whilst they are in close contact with each other. The glass mask, after being repeatedly being brought into close contact with the wafer, becomes soiled and, accordingly, requires cleaning before being used again in the process. More specifically, since the glass mask is brought into close contact with the wafer, which is coated with a photosensitive resin, or the like, the glass mask very readily becomes contaminated with fine residues of the photosensitive resin or the like, and accordingly dust in the atmosphere also sticks easily to the glass mask. Furthermore, sometimes alkaline substances ooze out from the glass mask itself and stick to the surfaces of the glass mask.

Conventionally, the cleaning of glass masks is performed by means of various pieces of cleaning apparatus.

One form of apparatus, which is specifically intended for cleaning single-crystal silicon wafers, which are somewhat similar as far as their cleaning requirements are concerned to glass masks used in the manufacture of semiconductor devices, is disclosed in US—A—4 109 337.

In this apparatus, each of a series of wafers, which are held side by side in a cassette, is pushed by a pusher member along a guide way and is passed first of all between a pair of spray nozzles and then into a nip formed between the peripheries of a pair of rotating cylindrical cleaning brushes. After the wafer has passed through the nip, it is drawn back again along the guide way by a puller member and it is moved back into the cassette. The cassette is then moved laterally through one step so that the pusher member then pushes the next wafer in the cassette along the guide way between the washing spray nozzles and through the nip. This cycle of operations is continued until all the wafers in the cassette have been washed.

Another form of apparatus, which is also intended for washing a series of thin disc-like wafers, is disclosed in US—A—3 939 514. In this apparatus the wafers are held by their edges between two parallel conveyor belts and the wafers are moved one after another by the belts in between the adjacent end faces of a number of pairs of rotating washing brushes. Adjacent each of the pairs of brushes there is a nozzle which sprays washing liquid onto the wafers as they move into the spaces between the brushes.

The passing of the wafers through a spray of washing liquid and the subsequent passage of the wafers between the washing members does not produce very effective cleaning because the movement of the washing members over the faces of the wafers removes the dirt from the surfaces and entrains it in the washing liquid on the surfaces, but since this washing liquid is not, during the time that the wafers are being cleaned by the brushes, flowing over the surfaces of the wafers, the dirt is not therefore carried away. Further, with a nip between the peripheral surfaces of cylindrical brushes as shown in US—A—4 109 337, the instantaneous area of contact between each of the brushes and the wafer is very small. In the arrangement shown in US—A—3 939 514 on the other hand in which the wafers pass between the end surfaces of two cylindrical washing brushes, the cleaning liquid is supplied from spray nozzles located radially outside the confronting ends of the rotating brushes and there is a tendency for a large proportion of the cleaning liquid to be flung centrifugally away from the rotating brushes before it has performed any cleaning action at all. What is more, there is a tendency for the supply of cleaning liquid to wash back onto the surfaces of the wafers being cleaned dirt which has been previously removed by the rotating brushes.

The object of the present invention is to overcome these disadvantages which are present in the prior art and to provide a machine which cleans glass masks for use in the manufacture of semiconductor devices much more effectively than the existing devices described above.

To this end, according to this invention, an apparatus as initially described is characterized in that the cleaning members are secured to the ends of two coaxial rotatable shafts and the cleaning surfaces are confronting end surfaces on the members, the end surfaces being provided with spiral grooves, and it is further characterized in that the means for supplying cleaning liquid comprise liquid supply conduits which extend through the shafts and lead to nozzles formed in the central portions of the confronting end surfaces, the nozzles being arranged to eject the cleaning liquid into the grooves.

With this apparatus, the cleaning liquid is delivered to a position in which it flows outwardly and uniformly over both sides of the glass mask being cleaned simultaneously and then the liquid is dispersed from the rotatable washing members by centrifugal force. The washing liquid therefore flows once over the surfaces of the mask being cleaned, picking up dirt as it flows, and the dirt is then directly carried away from the vicinity of the mask.

An example of an apparatus in accordance with the present invention is illustrated in the accompanying drawings in which:—

Figure 1 is a diagrammatic sectional view of the apparatus;

Figure 2 is a sectional view of part of the apparatus taken along line II—II in Figure 1, illustrating mainly, in side elevation, a pair of sponge drums; and

Figure 3 is an elevation looking axially of one of the sponge drums.

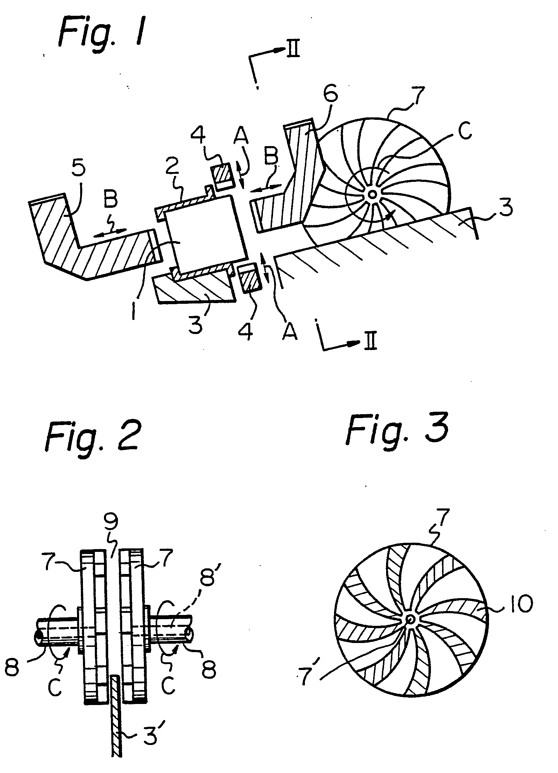

Referring to Figure 1, in the example of the apparatus which is illustrated, a plurality of glass masks 1 are contained in a cassette 2, which is removably secured to a cassette holding portion 3 of a loading stage. It should be appreciated that only one of the glass masks 1 is visible in Figure 1, because the glass masks 1 are parallel to each other and arranged in a row perpendicular to the plane of the paper. A pair of centering plates 4 are provided for the purpose of positioning exactly each individual glass mask 1 as the masks are moved one by one out of the cassette 2. The centering plates 4 are movable in the directions of arrows A and are adapted to grip the upper and lower edges of the glass mask 1 near one side edge thereof, whereby divergence and inclination of the mask are corrected. A pair of carriage members, that is, a feed-out plate 5 and a return plate 6, are provided for carriage of each individual glass mask 1. The carriage plates 5 and 6 are movable in the directions of arrows B, respectively, and are adapted to pinch the front and rear ends of the glass mask 1. When the carriage plates 5 and 6 have pinched the glass mask 1, then the centering plates 4 are separated from the glass mask 1; thereafter the glass mask 1 is carried by the carriage plates 5 and 6, on a guide portion 3' of the loading stage, to a position between a pair of cleaning elements, that is, sponge drums 7, and a glass mask is held in this position.

Referring to Figures 2 and 3, the sponge drums 7 are secured to shafts 8 which are adapted to be rotated in the directions of arrows C, respectively. The sponge drums 7 have end surfaces, which confront each other with a space 9 therebetween, and into this space the guide portion 3' extends. The confronting end surfaces, that is, cleaning surfaces, of the sponge drums 7 are adapted for wiping both surfaces of the glass mask 1 which is held by the carriage plates 5 and 6 in the position between these end surfaces, that is, between the sponge drums 7. The size of the space 9 i.e. the distance between the confronting cleaning surfaces, between the sponge drums 7 is variable. As illustrated in Figure 3, each sponge drum 7 is provided with a nozzle 7' for causing water to flow from the central portion of the cleaning surface thereof, and this nozzle 7' is in communication with a conduit 8' for the supply of water, which conduit is formed in the shaft 8. The cleaning surface of the sponge 7 is provided with spiral grooves 10 which extend from the central portion of the cleaning surface. In Figure 3, the spiral grooves 10 are illustrated with hatching lines for clear distinction.

When the two sponge drums 7 are rotated and pure water is supplied to the two nozzles 7' via the conduits 8', rotating jets of pure water are produced, by virtue of the spiral grooves 10 formed on the cleaning surfaces of the drums 7, on the surfaces of the glass mask held in the position between the drums. Accordingly, the glass mask held in the position between the sponge drums 7 is cleaned, in such a manner that both the surfaces thereof are wiped by the cleaning surfaces of the drums 7 and are washed by the above-mentioned rotating jets of pure water. In the case, for example, where a sufficient quantity of water is supplied and the sponge drums 7 are rotated at a rotation speed of 400 to 600 rpm for 2 to 5 seconds, the residues and dust on the surfaces of the glass mask are sufficiently removed.

After completion of the cleaning operation, the carriage plates 5 and 6 holding the glass mask are returned from the position between the sponge drums 7 to the position of the cassette 2, and then the carriage plates 5 and 6 are separated from the glass mask.

Subsequently, the cassette holding portion 3 of the loading stage is moved in the direction of the mask arrangement, that is, the direction perpendicular to the plane of the drawing paper in Figure 1, and the operation for cleaning the subsequent glass mask is started. After the cleaning of all the glass masks contained in the cassette 2 has been completed, the cassette 2 is taken out from the loading stage 3, and water is swished off the glass masks by a usual spin-drying method and then the glass masks are dried in a clean bench. In accordance with the spin-drying method, water can be completely swished off the masks by rotating the masks at a rotation speed of 1000 rpm for 40 seconds.

The apparatus for cleaning glass masks according to the present invention, one embodiment of which has been described above, provides for a very high cleaning effect. Accordingly, in the case where the degree of soiling is not too high, the glass masks can be cleaned completely by means of the sponge drums and the jet of pure water, even if a preliminary washing treatment is not performed.

By the cleaning apparatus of the present invention, dust and soil having a size of 1 to 1.5 $\mu$m or more can be removed, and more than 95% of the stuck solids can be washed away. In a case of a glass mask that has been used many times and in which the degree of soiling is high, and the soil is of a type that is difficult to remove, the cleaning effect can be improved by performing a preliminary washing treatment using chemicals.

The degree of soiling and the amount of stuck substances on the glass mask are determined by visual inspection and microscopic observation, and, based on these results, it is decided whether or not a preliminary washing treatment should be performed.

## Claims

1. An apparatus for cleaning glass masks for use in the manufacture of semiconductor devices, the apparatus comprising a pair of rotary cleaning members (7) having cleaning surfaces to wipe simultaneously both faces of a glass mask (1) in a cleaning position between the cleaning surfaces, means (7' 8') for supplying cleaning liquid between the members (7), supporting means (3) for supporting a cassette (2) in which a plurality of glass masks (1) are contained, and means (5, 6) for carrying the glass masks one by one between a position in the cassette and the cleaning position, characterised in that the cleaning members (7) are secured to the ends of two co-axial rotatable shafts (8) and the cleaning surfaces are confronting end surfaces on the members (7), the end surfaces being provided with spiral grooves (10), and in that the means for supplying cleaning liquid comprise liquid supply conduits (8') which extend through the shafts (8) and lead to nozzles (7') formed in the central portions of the confronting end surfaces, the nozzles (7') being arranged to eject the cleaning liquid into the grooves (10).

2. Apparatus according to Claim 1, characterized by a pair of members (4) which initially grip two opposite edges of each mask (1) in turn to centre the mask and align its faces with the confronting end surfaces before the mask is gripped by the means (5, 6) for carrying the mask to the cleaning position.

## Revendications

1. Un appareil pour le nettoyage de masques en verre destinés à être utilisés dans la fabrication des dispositifs semi-conducteurs, l'appareil comprenant une paire d'organes de nettoyages rotatifs (7) ayant des surfaces de nettoyage destinées à essuyer simultanément les deux faces du masque en verre (1) dans une position de nettoyage entre les surfaces de nettoyage, des moyens (7', 8') destinés à amener un liquide de nettoyage entre les organes (7), des moyens de support (3) destinés à supporter une cassette (2) dans laquelle une pluralité de masques en verre (1) est contenue, et des moyens (5, 6) destinés à transporter les masques en verre, un par un, entre une position dans la cassette et la position de nettoyage, caractérisé en ce que les organes de nettoyage (7) sont fixés aux extrémités de deux arbres coaxiaux rotatifs (8) et que les surfaces de nettoyage sont des surfaces d'extrémité se faisant face sur les organes (7), les surfaces d'extrémité présentant des gorges en spirale (10), et en ce que les moyens destinés à amener du liquide de nettoyage comprennent des conduits (8') d'alimentation en liquide, qui s'étendent dans les arbres (8) et mènent à des buses (7') formées dans les parties centrales des surfaces d'extrémité se faisant face, les buses (7') étant agencées afin d'éjecter le liquide de nettoyage dans les gorges (10).

2. Appareil selon la revendication 1, caractérisé par une paire d'organes (4) qui serre initialement deux bords opposés de chaque masque (1) à son tour, afin de centrer le masque et d'aligner ses faces avec les surfaces d'extrémité se faisant face, avant que le masque ne soit saisi par les moyens (5, 6) destinés à transporter le masque dans la position de nettoyage.

## Patentansprüche

1. Vorrichtung zur Reinigung von Glasmasken zur Verwendung bei der Herstellung von Halbleitervorrichtungen, mit einem Paar von rotierenden Reinigungsteilen (7), welche Reinigungsflächen haben, um gleichzeitig beide Seiten einer Glasmaske (1), welche sich in Reinigungsposition zwischen den Reinigungsflächen befindet, abzuwischen, mit Einrichtungen (7', 8') zur Zuführung von Reinigungsflüssigkeit zwischen die Teile (7), mit Halteeinrichtungen (3) zur Halterung einer Kassette (2), in welcher eine Anzahl von Glasmasken (1) enthalten sind, und mit Einrichtungen (5, 6), welche die Glasmasken eine nach der anderen zwischen einer Position in der Kasette und der Reinigungsposition tragen, dadurch gekennzeichnet, daß die Reinigungsteile (7) an den Enden von zwei koaxialen rotierbaren Achsen (8) befestigt sind und die Reinigungsflächen einander gegenüber angeordnete Stirnflächen der Teile (7) sind, wobei die Stirnflächen spiralförmige Nuten (10) aufweisen, und daß die Einrichtungen zur Zuführung der Reinigungsflüssigkeit Flüssigkeitsleitungen (8') umfassen, welche sich durch die Achsen (8) erstrecken und zu Düsen (7') führen, welche in den zentralen Abschnitten der einander gegenüber angeordneten Stirnflächen ausgebildet sind, wobei die Düsen (7') so angeordnet sind, daß sie die Reinigungsflüssigkeit in die Nuten (10) abgeben.

2. Vorrichtung nach Anspruch 1, dadurch gekennzeichnet, daß ein Paar von Teilen (4), welche anfänglich zwei entgegengesetzte Ränder jeder Maske (1) der Reihe nach greifen, um die Maske zu zentrieren und ihre Oberflächen mit den einander gegenüber angeordneten Stirnflächen auszurichten, bevor die Maske von den Einrichtungen (5, 6) gegriffen wird, um zu der Reinigungsposition getragen zu werden.

*Fig. 1*

*Fig. 2*

*Fig. 3*